## Europäisches Patentamt
## European Patent Office
## Office européen des brevets

(19)

(11) Numéro de publication : **0 219 512 B1**

(12)

# FASCICULE DE BREVET EUROPÉEN

(45) Date de publication du fascicule du brevet :
**13.12.89**

(21) Numéro de dépôt : **86901917.4**

(22) Date de dépôt : **02.04.86**

(86) Numéro de dépôt international :
**PCT/FR 86/00112**

(87) Numéro de publication internationale :
**WO/8606245 (23.10.86 Gazette 86/23)**

(51) Int. Cl.⁴ : **H 05 K 13/02, B 65 G 47/50**

(54) INSTALLATION DE MANUTENTION D'OBJETS FRAGILES EN ATMOSPHERE A EMPOUSSIEREMENT CONTROLE.

(30) Priorité : **12.04.85 FR 8505561**

(43) Date de publication de la demande :
**29.04.87 Bulletin 87/18**

(45) Mention de la délivrance du brevet :
**13.12.89 Bulletin 89/50**

(84) Etats contractants désignés :
**CH DE FR GB IT LI NL**

(56) Documents cités :
**DE—A— 3 124 063**
**US—A— 3 803 556**
**IBM Technical Disclosure Bulletin, volume 18, number 11, avril 1976, New York (US). T. Kehagiouglou: "Wafer transfer systems", pages 3696 and 3697**

(73) Titulaire : **SGS-THOMSON MICROELECTRONICS S.A.**
**7, Avenue Galliéni**
**F-94250 Gentilly (FR)**

(72) Inventeur : **ROCHET, André**
**17, av. du Vercors**
**F-38240 Meylan (FR)**
Inventeur : **DUBOIS, Guy**
**Le Reynand**
**F-38960 St. Etienne de Crossey (FR)**
Inventeur : **LALANNE, Alain**
**Lotissement les Evéquaux - Biviers**
**F-38330 St. Ismier (FR)**
Inventeur : **FAURE, Louis**
**149, bl. Joliot Curie**
**F-38600 Fontaine (FR)**

(74) Mandataire : **Rinuy, Santarelli**
**14, avenue de la Grande Armée**
**F-75017 Paris (FR)**

## Description

L'invention concerne la manutention (transport et stockage) d'objets au cours de leur fabrication selon le préambule de la première revendication.

On cherche de plus en plus à automatiser aussi complètement que possible la fabrication de toutes sortes d'objets, dans le but de réduire les coûts de fabrication tout en augmentant la fiabilité des produits obtenus.

On a bien réussi pour certains objets de grande série à automatiser largement certaines phases de fabrication. C'est le cas par exemple pour des opérations d'assemblage de pièces détachées simples, relativement robustes et peu affectées par les conditions ambiantes. Les opérations de découpage, collage, soudure, vissage etc. pour ce type de pièces posent des problèmes d'automatisation qui ont été assez bien résolus.

Le plus souvent les objets en cours de fabrication sont transportés d'un poste de travail à un autre par un convoyeur à bande (tapis roulant) sur lequel reposent les objets. Lorsqu'une opération sur un premier objet est terminée à un poste de travail, l'objet est repris par le convoyeur ; l'objet suivant arrive, poussé par le convoyeur sur le poste de travail pour subir le même traitement ; pendant ce temps le premier objet est transporté par le convoyeur jusqu'au poste suivant où il subit un autre traitement sans attendre ou avec une file d'attente aussi réduite que possible puisque les pièces sont traitées dans l'ordre de leur arrivée sur le convoyeur. Si les postes de travail individuels sont bien automatisés on peut arriver à un degré d'automatisation très élevé. Mais cela suppose :

que les objets à traiter soient robustes,

qu'ils supportent éventuellement des chocs les uns contre les autres lorsqu'il y a une file d'attente à l'entrée d'un poste de travail,

qu'ils supportent les accélérations ou décélérations provoquées par le passage souvent brutal du convoyeur en mouvement à un emplacement fixe du poste de travail et réciproquement,

qu'ils subissent tous les mêmes traitements dans l'ordre des postes de travail successifs le long du convoyeur,

que les traitements subis à chaque poste de travail aient des durées approximativement identiques.

Au contraire l'automatisation pose des problèmes particulièrement difficiles dans les circonstances où :

les objets à manipuler sont mécaniquement fragiles,

les opérations individuelles de fabrication sont longues et de durées très différentes les unes des autres,

les opérations ne se suivent pas forcément dans le même ordre pour les différents objets ou lots d'objets à fabriquer.

A cela s'ajoute une difficulté supplémentaire lorsque les objets doivent rester en atmosphère propre contrôlée (en particulier dépoussiérée) non seulement pendant les traitements successifs mais aussi entre les traitements.

La fabrication des circuits intégrés cumule ces difficultés dans ses premières phases de fabrication, c'est-à-dire pendant toutes les étapes de traitement qui s'effectuent sur les tranches semiconductrices avant qu'elles ne soient découpées en pastilles individuelles et encapsulées dans un boîtier étanche. C'est pourquoi on rencontre de nombreuses difficultés pour automatiser ces phases alors que l'automatisation des phases suivantes, et notamment le montage en boîtier, est beaucoup mieux maîtrisée.

Pourtant, le traitement automatisé des tranches en production industrielle est particulièrement désirable ; en effet, bien que l'atmosphère des salles de fabrication soit maintenue dans un état de propreté extrêmement contrôlée, le va et vient des personnes qui y travaillent est une source de pollution inévitable qui réduit considérablement les rendements de fabrication.

Divers systèmes de manutention spécifiques des tranches semiconductrices ont été proposés. Ces systèmes ne sont pas bâtis sur le principe général des convoyeurs à bande classiques pour au moins trois raisons découlant de ce qui a été dit ci-dessus : les tranches sont trop fragiles ; les traitements sont de durée trop longue et trop variables d'un traitement au suivant (plusieurs dizaines de minutes à plusieurs heures) ; on voudrait que les lots de tranches semiconductrices ne suivent pas tous la même succession de traitements, et en plus on voudrait que les lots puissent revenir ultérieurement vers une machine dans laquelle elles sont déjà passées : par exemple on peut avoir plusieurs implantations ioniques à effectuer, séparées par d'autres opérations (photolithographies) ; si on n'a qu'un seul implanteur il faut que les tranches reviennent plusieurs fois vers cet implanteur, ce qui n'est pratiquement pas envisageable industriellement avec une chaîne d'assemblage classique à convoyeur à bande.

Il faut insister tout particulièrement sur le fait que dans les processus de fabrication des circuits intégrés se pose un problème important de stockage intermédiaire des tranches, justement à cause des durées très longues de certaines opérations ; des lieux de stockage doivent être prévus pour qu'un lot de tranches puisse attendre, avant d'être amené à une machine, que cette machine ait fini le traitement commencé sur un autre lot. Ce stockage est, lui aussi, difficilement compatible avec l'organisation classique des chaînes d'assemblage automatisées, c'est-à-dire avec l'utilisation de convoyeurs à bande transportant des objets dans l'ordre d'un premier poste de travail à un dernier poste de travail.

C'est pourquoi les systèmes de manutention qui ont été proposés pour tenir compte des impératifs spécifiques du traitement des tranches de circuit intégré ont le plus souvent en commun les particularités suivantes : ils utilisent des chariots motorisés pour transporter des lots de tranches d'un endroit à un autre ; ces chariots sont guidés mécaniquement par des rails ou électroniquement par des pistes optiques ou électromagnétiques tracées sur te sol ; des aiguillages sont prévus pour que les chariots ne suivent pas un circuit fermé invariable mais puissent au contraire se diriger soit vers une machine soit vers une autre, soit encore vers un magasin de stockage intermédiaire ; il est essentiel de remarquer que les chariots sont tous motorisés pour être autonomes, afin qu'un chariot individuel puisse se déplacer d'une machine à une autre et s'arrêter précisément devant une machine ou un magasin pour effectuer un chargement ou un déchargement de tranches semiconductrices sans perturber le déplacement des autres chariots.

Les chariots motorisés doivent alors être équipés chacun d'une électronique sophistiquée pour assurer le contrôle de leurs déplacements (en fonction des lots qu'ils transportent) et surtout le contrôle très précis de leur arrêt à l'endroit exact où ils peuvent coopérer avec une machine pour effectuer un transfert de tranches. Dans certains systèmes les chariots deviennent de véritables robots autonomes.

Comme les chariots sont nombreux il en résulte un problème de fiabilité important : une panne sur un chariot risque de perturber considérablement l'ensemble du processus industriel puisque cette panne bloque non seulement le chariot considéré mais aussi les autres chariots qui se déplacent sur le même trajet.

Outre ce problème de fiabilité, la Demanderesse estime que ces systèmes de manutention présentent un inconvénient beaucoup plus grave qui est la difficulté de conserver une atmosphère ambiante suffisamment propre autour des tranches lorsqu'elles sont transportées par un chariot muni d'un moteur électrique. Les moteurs comportent des parties frottantes (pour le prélèvement du courant) créant des poussières métalliques, ils produisent des étincelles, et il sont dans l'ensemble source d'une pollution importante qu'on ne pourrait pratiquement éliminer suffisamment qu'en enfermant les tranches dans des boîtes étanches pendant leur transport. L'utilisation de boîtes étanches rendrait cependant très complexe l'introduction des tranches dans les machines de traitement. Sans boîte étanche, la pollution due principalement aux moteurs est trop grande même si on maintient les tranches sous un flux d'air dépoussiéré (la chaleur des moteurs perturbant d'ailleurs ce flux).

L'ensemble de l'exposé qui précède montre bien les contraintes très fortes et très variées qui rendent difficile l'automatisation de la manutention de certains produits comme les tranches de circuits intégrés en cours de fabrication.

Du document IBM Disclosure Bulletin, vol. 18, No 11, Avril 1976, pages 3696-3697, « Wafer transfer systems », T. KEHAGIOUGLOU, on connaît une installation de manutention d'objets fragiles, comprenant des chariots motorisés roulant sur des rails pour assurer le transport des objets en ambiance dépoussiérée, entre des machines de traitement.

Pour résoudre au mieux l'ensemble de ces problèmes, la présente invention propose une installation de manutention organisée tout à fait différemment de celles qui ont été proposées jusqu'à maintenant.

L'installation est une installation de manutention d'objets fragiles à conserver en ambiance à empoussièrement contrôlé, et elle est destinée à assurer :

le transport des objets entre des machines de traitement,

l'introduction des objets dans les machines et leur extraction,

le stockage provisoire des objets entre deux traitements successifs.

Cette installation comprend une série de chariots non motorisés roulant sur des rails suivant un trajet en circuit fermé passant à proximité des machines, les chariots étant fixés de place en place à une bande de traction sans fin entraînée à vitesse constante par une poulie le long d'un trajet parallèle à celui des rails. La bande de traction, les rails, et la poulie sont placés au-dessous d'une source d'air dépoussiéré fournissant un flux d'air vertical de haut en bas ; la poulie est entraînée par un moteur placé au-dessous d'elle et enfermé dans une enceinte. Chaque chariot comprend à sa partie supérieure un logement pour recevoir de manière amovible une cassette contenant les objets. Des outils de transfert automatique sont placés à proximité des rails pour prélever les cassettes sur les chariots ou les replacer sur des chariots vides ; chaque outil de transfert comporte une tête de préhension capable de se mouvoir en translation parallèlement au mouvement des chariots, et un système électronique de contrôle du mouvement de la tête pour détecter la position d'un chariot, asservir le mouvement de la tête à celui du chariot, et effectuer un transfert d'une cassette du chariot à la tête ou réciproquement pendant le mouvement synchrone du chariot et de la tête. A chaque chariot est associé un moyen d'identification reconnaissable par un moyen de détection électronique placé en amont de la tête de préhension d'un outil de transfert et couplé électriquement à celui-ci ; l'installation comprend enfin un processeur de traitement d'informations coopérant avec les outils de transfert pour assurer le transfert d'une cassette par un outil de transfert au début et à la fin d'un traitement qui doit être effectué sur cette cassette et un stockage provisoire des cassettes sur les chariots en mouvement entre des traitements successifs.

L'organisation qui est définie ci-dessus concerne un atelier de plusieurs machines placées autour d'un circuit fermé de rails de guidage, mais bien entendu une organisation industrielle plus complexe comprendra éventuellement plusieurs ateliers ayant chacun ce circuit fermé, avec des possibilités de transfert entre les circuits correspondants : dans ce cas, des outils de transfert peuvent être prévus également pour effectuer un transfert d'une cassette non pas d'un chariot vers une machine mais de ce chariot vers un chariot d'un autre circuit.

Etant donné qu'un aspect important de l'invention réside dans l'élimination des frottements qui sont cause de pollution, on prévoira des moyens pour que les chariots soient portés par des roues montées avec des roulements à bille autour d'axes (horizontaux) qui eux-mêmes peuvent pivoter autour d'un axe vertical ; ainsi les roues resteront en permanence parallèles aux rails même dans les parties non rectilignes du trajet suivi par ceux-ci.

Enfin les chariots pourront être carénés d'une manière minimisant les perturbations du flux d'air dans lequel ils sont placés.

On notera qu'avec le système proposé il est possible de placer les rails directement au-dessous d'un plafond constituant une source uniforme de flux d'air dépoussiéré, ce qui ne serait évidemment pas possible avec un convoyeur du type tapis roulant où le flux d'air se heurterait simplement au tapis roulant créant des perturbations considérables de ce flux. Ici, les rails et les chariots carénés espacés les uns des autres créent une faible perturbation et peuvent être efficacement placés dans un flux d'air dépoussiéré, y compris dans un flux laminaire d'air dépoussiéré.

D'autres caractéristiques et avantages de l'invention apparaîtront à la lecture de la description détaillée qui suit et qui est faite en référence aux dessins annexés dans lesquels :

la figure 1 représente une vue de dessus schématique de l'installation selon l'invention,

la figure 2 représente une élévation de cette installation,

la figure 3 représente une vue en perspective d'un chariot et d'une tête de préhension,

les figures 4, 5 et 6 représentent, respectivement en coupe transversale, en coupe longitudinale, et en vue de dessus, un exemple de chariot adapté à l'installation selon l'invention,

les figures 7 et 8 représentent en vue latérale et vue de face le mode de fixation du chariot sur la bande.

Etant donné que l'invention porte essentiellement sur l'architecture générale de l'installation selon l'invention il n'est pas nécessaire de décrire tous les détails de réalisation mécanique qui peuvent être extrêmement variés et qui dépendent non seulement des objets transportés, mais aussi des machines de fabrication, des locaux dans lesquels la fabrication est effectuée etc.

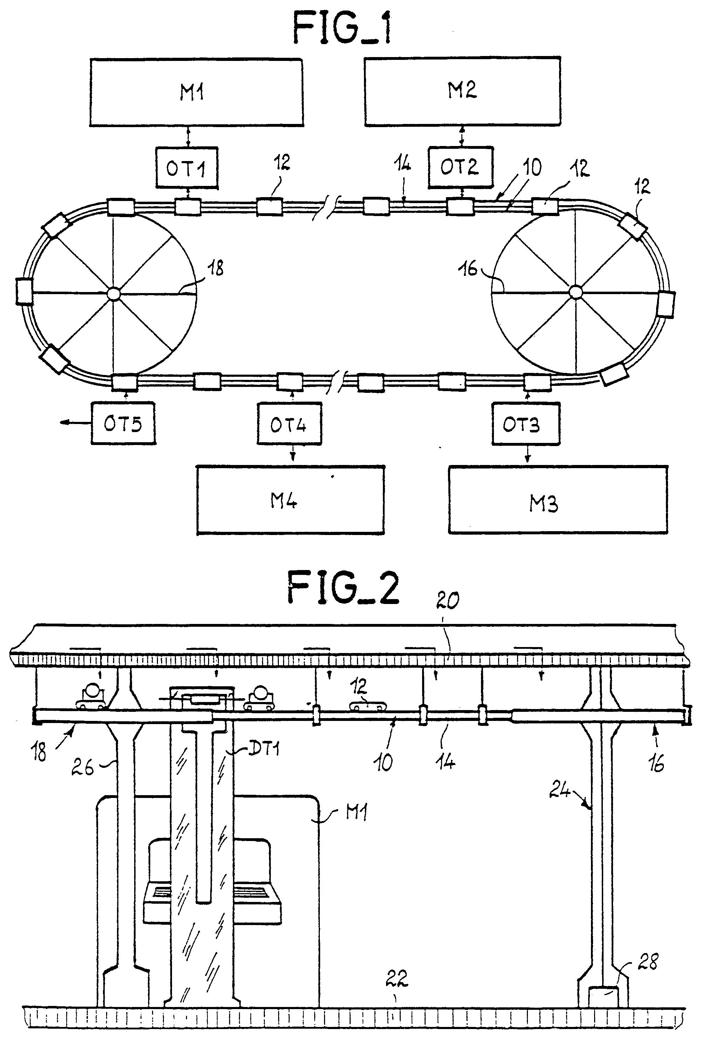

La figure 1 montre l'organisation d'un atelier dans lequel s'insère l'installation de manutention selon l'invention, appliquée au traitement de tranches semiconductrices.

On a représenté symboliquement par des blocs rectangulaires quatre machines de traitement M1, M2, M3, M4 desservies par l'installation de manutention, vue de dessus.

Cette installation comprend une ligne de transport tournant en boucle sans fin et des outils de transfert, ici cinq outils de transfert OT1, OT2, OT3, OT4, OT5, placés chacun à proximité de la ligne de transport et d'une machine de traitement respective, pour effectuer un transfert de pièces entre la ligne et la machine, le cinquième outil de transfert pouvant être placé par exemple entre la ligne et une autre ligne non représentée pour effectuer un transfert entre les deux lignes.

La ligne de transport est une ligne de chariots tractés ; les chariots sont des chariots roulants mais dépourvus de moteurs individuels.

La ligne de chariots tractés comprend des rails de guidage 10 sur lesquels reposent des chariots roulants 12, et une bande 14 de traction des chariots ; les chariots sont fixés de place en place sur la bande. Cette bande 14 est une bande sans fin entraînée à vitesse constante sur un trajet parallèle à celui des rails, par exemple entre deux rails parallèles. Des poulies 16 et 18 servent à l'entraînement, à la tension, et au guidage de la bande 14. L'une des poulies est entraînée par un moteur. Les chariots comportent chacun à leur partie supérieure un emplacement où l'on peut poser une cassette contenant un lot de tranches semiconductrices.

La figure 2 représente un aspect de l'installation vue en élévation.

Cette installation est de préférence placée dans une salle « blanche », c'est-à-dire une salle à atmosphère très contrôlée ; par exemple la salle comprend un plafond alvéolé 20 par lequel on souffle un flux d'air dépoussiéré et contrôlé en température, humidité et composition (de préférence en écoulement laminaire) ; le flux est vertical de haut en bas et l'écoulement de l'air est de préférence laminaire ; la salle comprend un plancher alvéolé 22 par lequel on récupère cet air.

Les rails de guidage peuvent être supportés de place en place à proximité du plafond par des crochets fixés au plafond. De cette manière les pièces à traiter circulent sous l'arrivée d'air dépoussiéré.

Les poulies sont supportées à la même hauteur que les rails de guidage ; elles peuvent être accrochées à partir du plafond ou du plancher. Sur la figure 2, on les a représentées comme étant montées sur des axes verticaux montés entre sol et plancher. Les axes sont logés dans des carénages de protection 24 et 26 et le moteur d'entraînement 28 avec son réducteur est également logé dans l'un des carénages et placé de préférence tout en bas.

Sur la figure 2 une seule machine M1 a été représentée pour ne pas charger la figure, avec un outil de transfert correspondant OT1.

En ce qui concerne l'outil de transfert, sa construction dépend essentiellement des objets à transporter, des possibilités de réception des objets à l'intérieur des machines de traitement, de la forme des cassettes qui contiennent les tranches semiconductrices et qui sont à prélever et à reposer sur les chariots. On ne va donc pas donner de détails d'exécution de ces outils, mais simplement les caractéristiques principales nécessaires à l'homme du métier pour la réalisation de ces outils, ainsi qu'une forme d'exécution simplifiée donnée simplement à titre d'exemple.

L'outil de transfert est relativement simple en ce sens qu'il n'a pas besoin d'être un véritable robot manipulateur (un robot manipulateur nécessiterait des possibilités de déplacement selon six ou sept axes différents). L'outil comportera une tête de préhension capable de se mouvoir selon trois axes ou directions, l'une des directions étant une direction parallèle à la direction d'avance des chariots. La construction la plus simple est une construction du type « pont roulant » (trois directions de translation perpendiculaires les unes aux autres).

Par exemple l'outil de transfert comportera une tête de préhension capable de se déplacer selon une première direction parallèle au trajet des chariots qui passent devant l'outil. Cette tête peut également se déplacer dans une deuxième direction, horizontale et perpendiculaire au trajet des chariots, et dans une troisième direction qui est verticale.

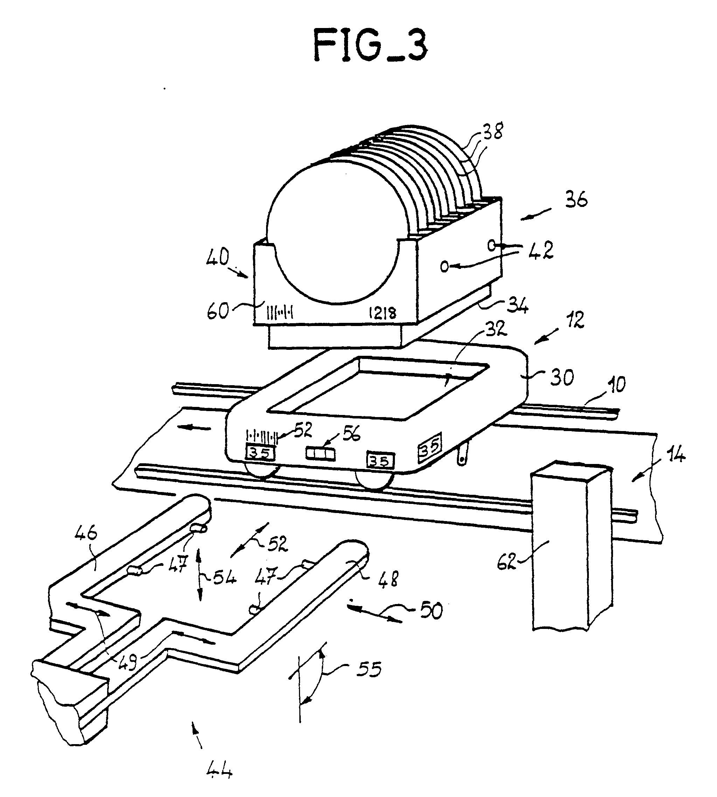

La figure 3 représente en perspective un exemple de réalisation de chariot avec une cassette de tranches et une tête de préhension. Ces trois éléments ont été écartés les uns des autres pour rendre le dessin plus compréhensible mais dans la réalité la cassette reposera soit sur le chariot soit sur la tête de préhension.

Dans cet exemple, le chariot comporte un châssis 30, caréné pour faciliter l'écoulement d'air dépoussiéré de haut en bas ; à la partie supérieure du châssis est prévu un évidement rectangulaire 32 tourné vers le haut, qui sert de logement pour la base rectangulaire 34 d'une cassette 36 portant un lot de tranches 38.

Les tranches sont placées verticalement pour faciliter l'écoulement de l'air, et l'évidement 32 est de préférence ouvert également vers le bas pour la même raison (la cassette 36 étant supposée également largement ouverte vers le bas entre les tranches).

La cassette 36 est pourvue de moyens d'accrochage destinés à coopérer avec la tête de préhension pour permettre le prélèvement d'une cassette ou la repose d'une cassette dans le logement 32, ce prélèvement et cette repose s'effectuant sans interruption de la marche du chariot tiré par la bande 12.

Dans l'exemple représenté, les moyens d'accrochage sont extrêmement simples : ce sont des trous horizontaux 40 et 42 de part et d'autre dans les bords latéraux de la cassette (bords latéraux perpendiculaires à la direction d'avance des chariots).

La tête de préhension, désignée par la référence 44, comporte une pince à deux bras horizontaux 46 et 48 pourvus de tétons horizontaux 47 en saillie. Les bras peuvent passer chacun le long d'un bord latéral de la cassette puis se resserrer l'un vers l'autre de manière à insérer les tétons 47 dans les trous 40 et 42. Lors des mouvements de la tête de préhension les bras 46 et 48 restent horizontaux (en pratique ils sont situés dans un même plan horizontal) de sorte que la cassette garde une orientation fixe lorsqu'elle est prélevée ou déposée sur un chariot par la tête de préhension. Le mouvement d'écartement et de resserrement des bras 46 et 48 est indiqué par des flèches 49.

Les quatre mouvements indépendants que peut accomplir la tête de préhension 44 sont indiqués par quatre flèches 50, 52, 54, 55. Ces mouvements ainsi que l'ouverture et la fermeture de la pince 46, 48 sont contrôlés par une électronique de commande faisant partie de l'outil de transfert, les différents outils de transfert recevant et transmettant par ailleurs des informations et des instructions à une unité de traitement globale pour l'atelier ou pour toute la chaîne de production.

Ces quatre mouvements sont de préférence une translation horizontale longitudinale 50, une translation horizontale transversale 52, une translation verticale 54, et une rotation 55 de 0 à 90° dans un plan vertical.

La tête de préhension 44 est pourvue d'un détecteur de position du chariot, coopérant avec des moyens de repérage placés sur le chariot (ou éventuellement sur la bande de traction) ; par exemple les moyens de repérage sont constitués par un motif de marques noires et blanches 56 tandis que le détecteur de position comprend plusieurs cellules photoélectriques et une optique de focalisation.

Le prélèvement d'une cassette sur un chariot s'accomplit de la manière suivante : la tête de détection est initialement à une position et une hauteur permettant au moyen de détection de reconnaître les marques de repérage. L'électronique de commande de l'outil de transfert comporte un asservissement qui commande la mise en mouvement de la tête dans la direction longitudinale 50 (parallèle au trajet du chariot), pour atteindre la même vitesse que le chariot, de manière que le moyen de détection se centre et reste centré sur les marques de repérage ; pendant le mouvement synchrone du chariot et de la tête, la tête est amenée dans la direction transversale 52 (horizontale et perpendiculaire au trajet du chariot) et les bras 46 et 48 de la pince sont refermés avec introduction des tétons 47 dans les trous 42 des bords latéraux de la cassette : le mouvement synchrone dans la direction longitudinale continue et un mouvement vertical vers le haut (flèche 54) est appliqué pour soulever la cassette qui peut se séparer du chariot ; à partir de là les mouvements de la tête de préhension ne sont dictés que par l'endroit où on veut transporter la cassette ; la rotation 55 dans le plan vertical permet notamment de déposer la cassette.

La repose d'une cassette sur un chariot s'effectue d'une manière tout à fait analogue c'est-à-dire en mettant la tête de préhension d'abord en mouvement longitudinal synchrone du mouvement du chariot ; puis, pendant le mouvement longitudinal synchrone, un mouvement transversal est effectué vers le chariot suivi d'un mouvement vertical vers le bas ; enfin un nouveau mouvement transversal est effectué pour retirer la fourche, après avoir ouvert la pince 46/48. Après cela, le mouvement longitudinal synchrone peut être interrompu et la tête de préhension peut reprendre une position d'attente où une nouvelle détection de passage d'un chariot peut avoir lieu.

On prévoira des marques d'identification des chariots (et éventuellement des cassettes) et un appareil de reconnaissance de ces marques d'identification (par exemple une tête de reconnaissance fixe placée à proximité immédiate du trajet des chariots, en amont de la tête de préhension). Les marques d'identification peuvent consister en un code à barres 58 sur le chariot et/ou 60 sur la cassette ; l'appareil de reconnaissance 62 peut faire partie de l'outil de transfert ou être distinct mais dans ce cas il est relié électriquement à l'outil de transfert pour qu'un mouvement de la tête de préhension 44 en vue de la dépose ou du prélèvement d'une cassette ne s'effectue que si c'est un chariot bien déterminé qui a été reconnu en amont de la tête de préhension. On peut prévoir que l'information d'identification, fournie par l'appareil de reconnaissance est traitée par un microprocesseur de gestion de l'ensemble de l'atelier, qui donne à l'outil de transfert un ordre de prélèvement ou de repose de cassette à un moment correspondant au passage d'un chariot précisément désigné. L'électronique de commande de l'outil de transfert assure quant à elle tout le déroulement de l'opération de prélèvement ou de repose à partir du moment où l'ordre est reçu.

La tête de reconnaissance des marques d'identification peut être une tête classique de lecture de codes à barres si les marques d'identification sont des codes à barres.

Des marques d'identification intelligibles seront également prévues sur les chariots et sur les cassettes de façon à pouvoir assurer un dépannage manuel sans perturbation : les chariots auront des numéros consécutifs permettant de les repérer rapidement pour prélever ou poser une cassette après avoir éventuellement interrogé le microprocesseur de gestion pour savoir sur quel chariot il y a lieu de prélever ou poser une cassette ayant un numéro déterminé.

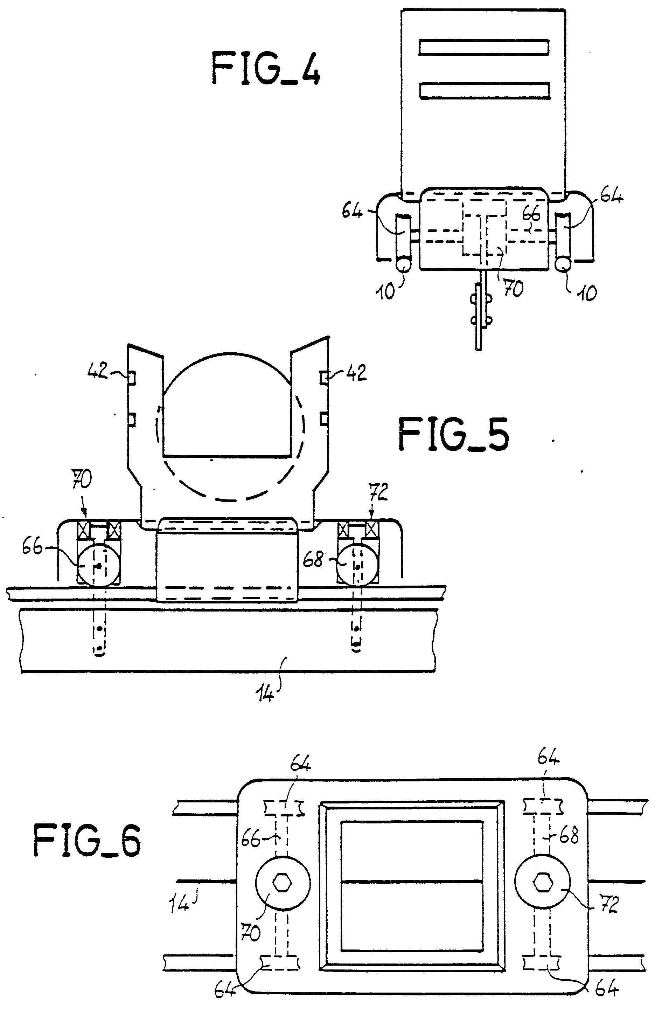

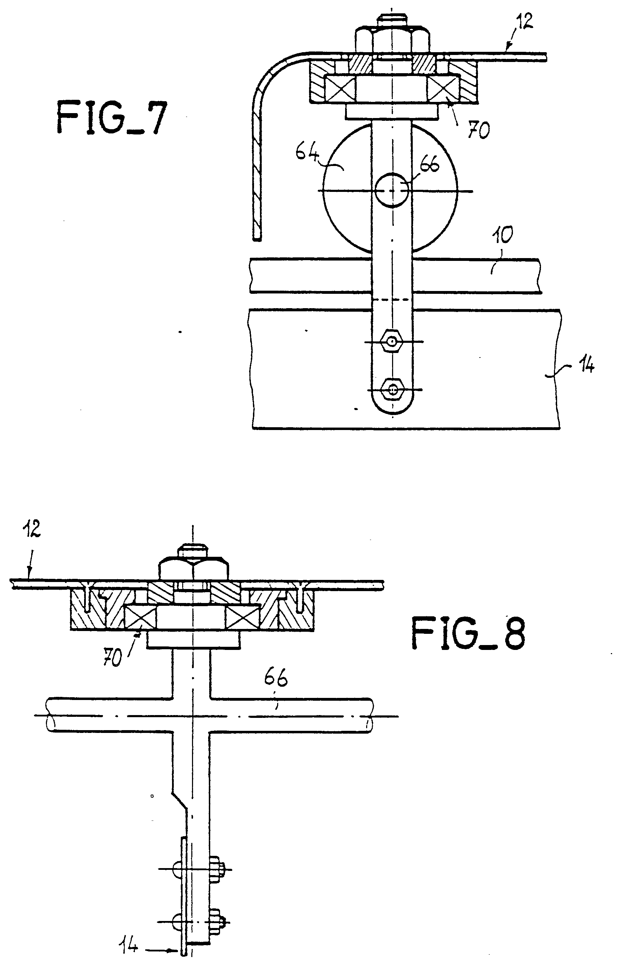

Les figures 4, 5 et 6 montrent de manière simplifiée, respectivement en coupe transversale, en coupe longitudinale, et en vue de dessus un exemple de constitution de chariot roulant adapté à l'installation selon l'invention. Les figures 7 et 8 en montrent des détails.

La bande 12 à laquelle sont fixés les chariots pour être tractés est de préférence une bande d'acier inoxydable (feuillard d'acier). Les rails de guidage 10 peuvent être à section rectangulaire ou ronde, cette dernière forme réduisant les frottements. Les roues 64 du chariot présentent des gorges facilitant le guidage latéral du chariot.

Ces roues sont montées avec des roulements à billes sur des essieux, respectivement un essieu avant 66 et un essieu arrière 68.

Les essieux sont eux-mêmes rigidement fixés à la bande 12 sensiblement au centre des essieux ; de cette manière l'essieu reste en permanence perpendiculaire au plan (vertical) de la bande, y compris lorsque la bande tourne (autour des poulies).

Mais le chariot est porté par les essieux par l'intermédiaire de roulements à bille 70 et 72, d'axes verticaux, qui autorisent une rotation libre et sans frottement de l'essieu par rapport au chariot dans un plan horizontal. Ces essieux pivotants aident considérablement à la réduction des frottements dans les courbures des rails de guidage.

Enfin, pour éviter des tensions entre le chariot et la bande dans les parties courbes des rails de guidage, on peut prévoir que c'est seulement à l'avant du chariot que l'essieu est fixé rigidement à la bande ; dans ce cas on prévoit que l'essieu arrière est fixé à la bande avec un degré de liberté longitudinal de quelques dixièmes de millimètres ; on peut aussi fixer rapidement l'essieu arrière à la bande ; dans ce cas on laissera entre le chariot et l'essieu arrière un degré de liberté longitudinal de la même amplitude par glissement ou flexion.

## Revendications

1. Installation de manutention d'objets fragiles à conserver en ambiance dépoussiérée, destinée à assurer le transport des objets entre des machines de traitement (M1 à M4), l'introduction des objets dans les machines et leur extraction, et le stockage provisoire des objets entre deux traitements successifs, cette installation étant caractérisée par les dispositions suivantes :

elle comprend une série de chariots (12) non motorisés roulant sur des rails (10) suivant un trajet en circuit fermé passant à proximité des machines (M1 à M4), les chariots étant fixés de place en place à une bande de traction sans fin (14) entraînée à vitesse constante par une poulie (16) le long d'un trajet parallèle à celui des rails ;

la bande de traction, les rails et la poulie sont placés au-dessous d'une source d'air dépoussiéré fournissant un flux d'air vertical de haut en bas, la poulie étant entraînée par un moteur placé au-dessous d'elle ;

chaque chariot (12) comprend à sa partie supérieure un logement pour recevoir de manière amovible une cassette (36) contenant les objets ;

des outils de transfert automatique (OT1 à OT5) sont placés à proximité des rails pour prélever les cassettes sur les chariots ou les replacer sur des chariots vides ; chaque outil de transfert comporte une tête de préhension (44) capable de se mouvoir en translation parallèlement au mouvement des chariots, et un système électronique de contrôle du mouvement de la tête, apte à détecter la position d'un chariot et à asservir le mouvement de la tête sur celui du chariot, et effectuer un transfert d'une cassette du chariot à la tête ou réciproquement pendant un mouvement synchrone du chariot et de la tête ;

à chaque chariot est associé un moyen d'identification reconnaissable par un moyen de détection électronique placé en amont de la tête de préhension d'un outil de transfert, et couplé électriquement à celui-ci, l'installation comportant encore un processeur de traitement d'informations coopérant avec les outils de transfert pour assurer le transfert d'une cassette par un outil de transfert au début et à la fin d'un traitement qui doit être effectué sur cette cassette et un stockage provisoire des cassettes sur les chariots en mouvement entre des traitements successifs.

2. Installation de manutention d'objets fragiles à conserver en ambiance dépoussiérée selon la revendication 1, caractérisée en ce que la tête de préhension des outils de transfert comporte trois degrés de liberté de mouvement, permettant des déplacements en translation selon trois directions perpendiculaires les unes aux autres, l'une étant parallèle au trajet des chariots à proximité immédiate de l'outil de transfert considéré.

3. Installation selon la revendication 2, caractérisée en ce que la tête de préhension comporte un degré de liberté supplémentaire pour pouvoir se mouvoir en rotation dans un plan vertical.

4. Installation de manutention d'objets fragiles à conserver en ambiance dépoussiérée selon la revendication 1, caractérisée en ce que les chariots comportent des roues montées avec des roulements à bille sur des essieux fixés à la bande de traction, chaque essieu étant lui-même fixé à un axe vertical et le chariot étant porté par un roulement à bille permettant la rotation libre, par rapport à cet axe vertical, de l'essieu par rapport au chariot.

## Claims

1. An installation for holding fragile objects to be stored in a dust-free atmosphere which is adapted to transport objects between processing machines (M1 to M4), to insert the objects into the machines and to extract them, and to store the objects temporarily between two successive processing treatments, this installation being characterized by the following arrangements :

it comprises a series of non-motorized carriages (12) which roll on rails (10) along a closed circuit path which passes near the machines (M1 to M4), the carriages being fixed at intervals on an endless conveyor belt (14) driven at a constant speed by a pulley (16) along a path parallel to that of the rails ;

the conveyor belt, the rails and the pulley are located below a source of dust-free air supplying a vertical stream of air downwards, the pulley being driven by a motor located beneath it ;

in its upper part each carriage (12) comprises a housing to hold, removably, a cassette (36) containing the objects ;

tools for automatic transfer (OT1 to OT5) are located near the rails to lift the cassettes from the carriages or to replace them in empty carriages ; each transfer tool comprises a gripping head (44) able to move in translation parallel to the movement of the carriages, and an electronic system for controlling the movement of the head, which system is adapted to detect the position of a carriage, to control the movement of the head in relation to that of the carriage, and to effect a transfer of a cassette from the carriage to the head, or from the head to the carriage, during a synchronous movement of the carriage and the head ;

each carriage has a means of identification associated with it, which means can be recognized by an electronic detection means which is located ahead of the gripping head of a transfer tool and is electrically coupled to the latter, and the installation also comprises an information processor which cooperates with the transfer tools to ensure the transfer of cassette by a transfer tool at the start and at the end of a treatment which must be performed on this cassette and to ensure the temporary storage of cassettes on the carriages moving between successive treatments.

2. An installation for holding fragile objects to be stored in a dust-free atmosphere according to claim 1, characterized in that the gripping bead of the transfer tools has three degrees of freedom of movement which allow translational displacements in three directions perpendicular to one another, one of them being parallel to the path of the carriages immediately adjacent to the transfer tool in question.

3. An installation according to claim 2, characterized in that the gripping head has an additional degree of freedom to be able to move in rotation in a vertical plane.

4. An installation for holding fragile objects to be stored in a dust-free atmosphere according to claim 1, characterized in that the carriages comprise wheels mounted with ball bearings on axles fixed to the conveyor belt, each axle being itself fixed to a vertical shaft and the carriage being supported on a ball bearing which allows free rotation relative to this vertical shaft, of the axle relative to the carriage.

## Patentansprüche

1. Einrichtung für das Transportieren von zerbrechlichen Gegenständen, die in staubfreier Atmosphäre gehalten werden müssen, zu deren Transport zwischen Bearbeitungsmaschinen (M1 bis M4), deren Einführung in diese Maschinen und ihre Entnahme von diesen sowie zur Zwischenspeicherung der Gegenstände zwischen zwei aufeinanderfolgenden Bearbeitungen, gekennzeichnet durch folgende Merkmale :

eine Reihe von unmotorisierten Transportwagen (12), die auf Schienen (10) laufen, welche in einer geschlossenen Kreisbahn nahe bei den Maschinen (M1 bis M4) vorbeiführen, wobei die Transportwagen hintereinander an einem endlosen Zugband (14) befestigt sind, das mit konstanter Geschwindigkeit von einer Treibscheibe (16) längs einer Bahn parallel zu der der Schienen bewegt wird ;

das Zugband, die Schienen und die Treibscheibe sind unter einer Quelle staubfreier Luft angeordnet, die einen vertikalen Luftstrom von oben nach unten liefert,. wobei die Treibscheibe von einem unter ihr angebrachten Motor angetrieben wird ;

jeder Transportwagen (12) weist auf seinem oberen Bereich eine Ausnehmung zur auswechselbaren Aufnahme einer die Gegenstände enthaltenden Kassette (36) auf ;

nahe bei den Schienen sind automatische Umsetzeinrichtungen angebracht, um die auf den Wagen befindlichen Kassetten abzunehmen oder sie wieder auf die leeren Wagen abzusetzen, wobei jede Umsetzeinrichtung einen Greifkopf (44), der eine Umsetzbewegung parallel zur Wagenbewegung ausführen kann, sowie für dessen Bewegung ein elektronisches Steuersystem aufweist, durch das die Position eines Wagen feststellbar, die Bewegung des Greifkopfes an die des Wagens anpaßbar und die Übernahme einer Kassette vom Wagen auf den Greifkopf oder umgekehrt während einer synchronen Bewegung zwischen Wagen und Greifkopf bewirkbar ist ;

an jedem Wagen ist ein Identifikationsmittel angebracht, das von einem in Transportrichtung vor dem Greifkopf einer Umsetzeinrichtung angeordneten elektronischen Detektor feststellbar und elektrisch mit diesem geschaltet ist, und wobei noch ein Rechner zur Verarbeitung von Informationen vorgesehen ist, der mit den Umsetzeinrichtungen zur Sicherstellung der Umsetzung einer Kassette durch eine Umsetzeinrichtung zu Beginn und am Ende einer an dieser Kassette vorzunehmenden Behandlung sowie einer Zwischenspeicherung der Kassetten auf den Wagen während deren Bewegung zwischen aufeinanderfolgenden Behandlungen zusammenwirkt.

2. Einrichtung für das Transportieren von zerbrechlichen Gegenständen, die in staubfreier Atmosphäre gehalten werden müssen, nach Anspruch 1, dadurch gekennzeichnet, daß der Greifkopf der Umsetzeinrichtungen drei Freihaltsgrade für seine Bewegungen aufweist, wodurch Verschiebebewegungen längs drei zueinander senkrechten Achsen möglich sind, deren eine parallel zur Bahn der Wagen in unmittelbarer Nähe der jeweiligen Umsetzeinrichtung liegt.

3. Einrichtung nach Anspruch 2, dadurch gekennzeichnet, daß der Greifkopf einen zusätzlichen Freiheitsgrad für eine Drehbewegung in einer vertikalen Ebene aufweist.

4. Einrichtung für das Transportieren von zerbrechlichen Gegenständen, die in staubfreier Atmosphäre gehalten werden müssen, nach Anspruch 1, dadurch gekennzeichnet, daß die Wagen mit Kugellagern auf an dem Zugband befestigten Radachsen montierte Räder aufweisen, wobei jede Radachse ihrerseits an einer vertikalen Achse befestigt ist und der Wagen von einem Kugellager getragen wird, das in Bezug auf diese Vertikalachse eine freie Drehung der Radachse relativ zum Wagen zuläßt.

# FIG_1

M1

M2

OT1  12   14  OT2   10  12   12

18   16

OT5   OT4   OT3

M4   M3

# FIG_2

20

18  26  DT1  12  10  14  16

24

M1

28

22

# FIG_3

FIG_4

64    66    64
10    70    10

42    42

FIG_5

70    72
66    68

14

64    64

FIG_6

66    68
14    72
70
64    64

FIG_7

12

70

64

66

10

14

FIG_8

12

70

66

14